# EUROPÄISCHE PATENTSCHRIFT

(11) **EP 1 309 042 B1**
(45) Veröffentlichungstag und Bekanntmachung des Hinweises auf die Patenterteilung: **28.12.2005**
(21) Anmeldenummer: 02022921.7
(22) Anmeldetag: 10.10.2002
(51) Int. Cl.: H01R 13/646

(54) **Federblech zum Kontaktieren eines Bauteils auf einer Leiterplatte**
Contact spring for a component on a print board
Ressort de contact pour composant sur circuit imprimé

(30) Priorität: 05.11.2001 DE 20117997 U
(43) Veröffentlichungstag der Anmeldung: 07.05.2003
(73) Patentinhaber: Rosenberger Hochfrequenztechnik GmbH & Co., 83413 Fridolfing (DE)
(72) Erfinder: Rosenberger, Bernhard, 84529 Tittmoning (DE)
(74) Vertreter: Zeitler, Giselher

(56) Entgegenhaltungen:
- EP-A- 0 627 788
- DE-A- 3 430 589
- FR-A- 2 618 250
- US-A- 4 626 812
- US-A- 5 178 562

## Beschreibung

Die vorliegende Erfindung betrifft ein Federblech für ein elektrisches bzw. elektronisches Bauteil mit Federstiften zum Befestigen auf einer Leiterplatte gemäß dem Oberbegriff des Anspruchs 1. Die Erfindung betrifft ferner eine Schaltungsanordnung mit einer Leiterplatte und wenigstens einem elektrischen bzw. elektronischen Bauteil mit Federstiften zum Befestigen des Bauteils auf der Leiterplatte gemäß dem Oberbegriff des Anspruchs 2.

Elektronische Bauteile werden herkömmlicherweise mit entsprechenden Beinchen des Bauteils in entsprechende Löcher in einer Leiterplatte eingeführt und zum Herstellen einer mechanischen Halterung des Bauteils auf der Platine sowie entsprechender elektrischer Kontakte zwischen den Beinchen und einer elektronischen Schaltung auf der Leiterplatte gelötet. Um den Lötvorgang einzusparen ist es ferner bekannt, die Beinchen des Bauteils als Federstifte auszubilden, wobei die Federstifte beim Eindrücken in die Löcher der Leiterplatte sowohl eine mechanische Halterung als auch einen elektrischen Kontakt mit einer Leiterbeschichtung in den Löchern herstellen. Für die Funktion der sicheren mechanischen Halterung des Bauteils in den Löchern der Leiterplatte ist es jedoch erforderlich, die Federstifte mit entsprechender Länge auszubilden. Dies ist jedoch dann nachteilig, wenn das Bauteil Teil einer Hochfrequenzschaltung ist und über die Federstifte HF-Signale übertragen werden. Einerseits strahlen die langen Federstifte HF-Energie ab, andererseits kann es zu Einkopplungen von HF-Energie in die Hochfrequenzschaltung über die als Antenne wirkenden Federstifte kommen. Dieses Problem verschärft sich noch dadurch, dass zwischen Bauteil und Kontakt zur Leiterplatte über die Federstifte keine exakte Impedanzkontrolle herrscht. Da das Bauteil nicht unmittelbar auf der Leiterplatte aufliegt, sondern einen gewissen Abstand hat, der einen Spalt zwischen Bauteil und Leiterplatte bedingt, gibt es im Bereich der Federstifte einen nicht abgeschirmten Bereich, der Abstrahlung und Einkopplung ebenfalls in unerwünschter Weise begünstigt.

Eine solche Schaltungsanordnung ist z. B. aus US-A-4 626 812 bekannt.

Der Erfindung liegt die Aufgabe zugrunde, ein Federblech und eine Schaltungsanordnung der o.g. Art derart bzgl. ihrer HF-Eigenschaften zu verbessern, ohne dabei den Vorteil einfacher Prozessgestaltung bei der Herstellung zu verlieren. Ferner soll eine Rückwärtskompatibilität zu bisherigen Prozessen Baugruppen bestehen bleiben.

Diese Aufgabe wird erfindungsgemäß durch ein Federblech der o.g. Art mit den in Anspruch 1 gekennzeichneten Merkmalen und durch eine Schaltungsanordnung der o.g. Art mit den in Anspruch 2 gekennzeichneten Merkmalen gelöst. Vorteilhafte Ausgestaltungen der Erfindung sind in den weiteren Ansprüchen beschrieben.

Bei einem Federblech der o.g. Art ist es erfindungsgemäß vorgesehen, dass das Federblech als Quadrat mit einer mittigen kreisförmigen Ausnehmung ausgebildet ist, wobei die kreisförmige Ausnehmung auf den Diagonalen des Quadrats zusätzliche Ausbuchtungen aufweist, wobei das Federblech wenigstens eine federnde, bogenförmige Erhebung aufweist, so dass wenn das Federblech zwischen Bauteil und Leiterplatte angeordnet ist wenigstens einen elektrischen Kontakt zwischen wenigstens einem Teil des Bauteils und wenigstens einer entsprechenden Kontaktfläche auf der Leiterplatte anstatt wenigstens eines Federstiftes herstellt.

Dies hat den Vorteil, daß die Funktionen "Haltern des Bauteils auf der Leiterplatte" und "elektrische Kontaktierung mit einer Schaltung auf der Leiterplatte" wenigstens teilweise getrennt sind und durch unterschiedliche Komponenten realisiert werden.

Dadurch können einerseits die Federstifte auf die Funktion "Halterung" und andererseits das Federblech auf die Funktion "elektrische Kontaktierung" unabhängig voneinander optimiert werden. Ferner entfällt bei HF-Anwendungen eine unerwünschte Ein- oder Abstrahlung von HF-Energie über solche Federstifte, die nicht mehr elektrischen Kontakt herstellen und ein entsprechendes HF-Signal übertragen müssen. Zusätzlich ist ein impedanzkontrollierter Übergang vom Bauteil zur Leiterplatte ohne Löttechnik und ohne reine Surface-Mount-Technik sowie ggf. ohne Änderung von Bauteilen, Leiterplatte und Herstellungsprozess sicher gestellt. Hierdurch kann für bereits bestehende Anwendungen bzw. Prozesse eine Rückwärtskompatibilität bei gleichzeitig besseren HF-Eigenschaften sichergestellt werden.

Bei einer Schaltungsanordnung der o.g. Art ist es erfindungsgemäß vorgesehen, dass zwischen Leiterplatte und wenigstens einem Bauteil ein Federblech angeordnet ist, welches als Quadrat mit einer mittigen kreisförmigen Ausnehmung ausgebildet ist, wobei die kreisförmige Ausnehmung auf den Diagonalen des Quadrats zusätzliche Ausbuchtungen aufweist und wobei das Federblech wenigstens eine federnde, bogenförmige Erhebung aufweist, so dass das Federblech wenigstens einen elektrischen Kontakt zwischen wenigstens einem Teil des Bauteils und wenigstens einer entsprechenden Kontaktfläche auf der Leiterplatte anstatt wenigstens eines Federstiftes herstellt.

Dies hat den Vorteil, dass die Funktionen "Haltern des Bauteils auf der Leiterplatte" und "elektrische Kontaktierung mit einer Schaltung auf der Leiterplatte" wenigstens teilweise getrennt sind und durch unterschiedliche Komponenten realisiert werden. Dadurch können einerseits die Federstifte auf die Funktion "Halterung" und andererseits das Federblech auf die Funktion "elektrische Kontaktierung" unabhängig voneinander optimiert werden. Ferner entfällt bei HF-Anwendungen eine unerwünschte Ein- oder Abstrahlung von HF-Energie über solche Federstifte, die nicht mehr elektrischen Kontakt herstellen und ein entsprechendes HF-Signal übertragen müssen. Zusätzlich ist ein impedanzkontrollierter Übergang vom Bauteil zur Leiterplatte ohne Löttechnik und ohne reine Surface-Mount-Technik sowie ggf. ohne Änderung von Bauteilen, Leiterplatte und Herstellungsprozess sicher gestellt. Hierdurch kann für bereits bestehende Anwendungen bzw. Prozesse eine Rückwärtskompatibilität bei gleichzeitig besseren HF-Eigenschaften sichergestellt werden.

Eine besonders gute Abschirmung für HF-Anwendungen erzielt man dadurch, dass das Bauteil ein Gehäuse aus einem leitenden Werkstoff aufweist und das Federblech derart ausgebildet ist, dass es einen elektrischen Kontakt zwischen dem Gehäuse und entsprechenden Massekontakten auf der Leiterplatte herstellt.

Beispielsweise ist das Bauteil ein HF-Bauteil, insbesondere ein Koaxialkuppler.

Eine optimale Anpassung an das Bauteil derart, dass Federstifte des Bauteils durch das Federblech hindurch greifen können erzielt man dadurch, dass das Federblech eine Umfangsgeometrie, welche einer Umfangsgeometrie des Bauteils entspricht, und im Bereich der Federstifte des Bauteils wenigstens eine Ausnehmung aufweist.

Beispielsweise umfasst Kontaktfläche auf der Leiterplatte wenigstens eine Leiterbeschichtung einer Durchkontaktierung der Leiterplatte und/oder wenigstens einen Footprint auf der Leiterplatte.

Die Erfindung wird im Folgenden anhand der Zeichnung näher erläutert. Diese zeigt in:
- Fig. 1: eine bevorzugte Ausführungsform eines erfindungsgemäßen Federbleches in Aufsicht,
- Fig. 2: in Seitenansicht,
- Fig. 3: in perspektivischer Ansicht,
- Fig. 4: ein Bauteil in Form eines Koaxialwinkelsteckers mit dem Federblech gemäß Fig. 1 in perspektivischer Ansicht,
- Fig. 5: in einer Ansicht von unten und
- Fig. 6: das Bauteil gemäß Fig. 4 nach Montage auf einer Leiterplatte in schematischer Seitenansicht.

Nachfolgend wird die Erfindung lediglich beispielhaft anhand eines Koaxialwinkelsteckers beschrieben. Die Erfindung ist jedoch nicht auf ein derartiges Bauteil beschränkt, sondern kann bei jedem beliebigen elektrischen bzw. elektronischen Bauteil mit Federstiften Verwendung finden.

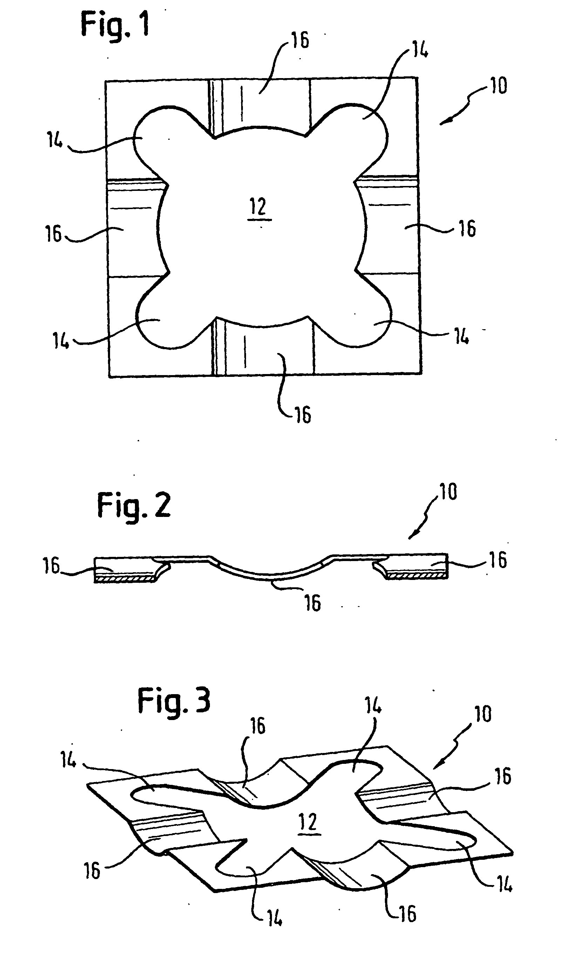

Die aus Fig. 1 bis 3 ersichtliche, bevorzugte Ausführungsform eines erfindungsgemäßen Federbleches 10 ist als Quadrat mit einer mittigen, kreisförmigen Öffnung 12 ausgebildet. Auf den Diagonalen des Quadrats ist die mittigen, kreisförmigen Öffnung 12 mit zusätzlichen Ausnehmungen 14 versehen. Die Bereiche 16 bilden federnde Erhebungen.

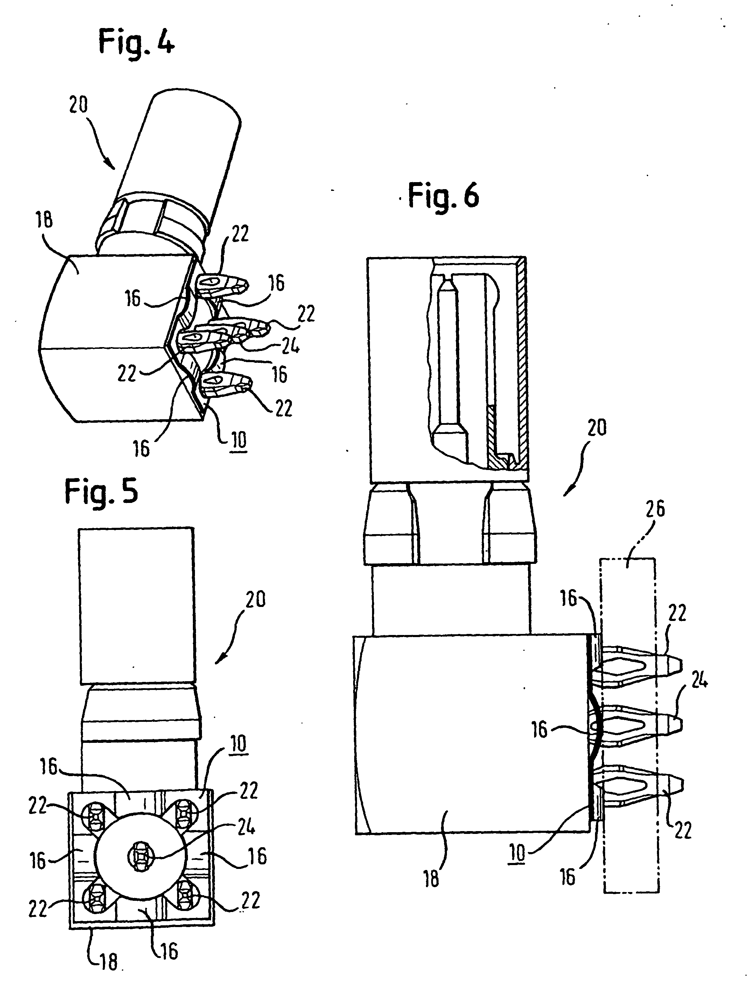

Wie aus den Fig. 4 und 5 ersichtlich, ist das Federblech 10 derart ausgebildet, daß es in seiner quadratischen Umfangsgeometrie einer Umfangsgeometrie eines Gehäuses 18 eines Koaxialwinkelsteckers 20 an dessen Kontaktierungsseite entspricht, wobei die zusätzlichen Ausnehmungen 14 genau an den Stellen ausgebildet sind, an denen sich äußere Federstifte 22 von dem Koaxialwinkelstecker 20 erheben. Die mittige, kreisförmige Öffnung 12 des Federbleches 10 ermöglicht einem mittigen Federstift 24 des Koaxialwinkelsteckers 20 das Durchgreifen des Federbleches 10. Zur Abschirmung ist das Gehäuse 18 aus Metall gefertigt. Dieser Koaxialwinkelstecker 20 dient als Koaxialkuppler zu einer Schaltung auf einer Leiterplatte. Die äußeren Federstifte 22 sollen dabei einen elektrischen Kontakt zu einem Massepotential auf der Leiterplatte und der mittlere Federstift 24 soll einen elektrischen Kontakt zu einer Signalleitung auf der Leiterplatte herstellen.

Fig. 6 veranschaulicht schematisch einen Koaxialwinkelstecker 20, welcher auf einer Leiterplatte 26 montiert ist, wobei das Federblech 10 zwischen Koaxialwinkelsteckers 20 und Leiterplatte 26 angeordnet ist. Das Federblech 10 kontaktiert durch die federnde Wirkung der Abschnitte 16 einerseits das metallische Gehäuse 18 und andererseits im Bereich der federnden Erhebungen 16 entsprechende Metallbeschichtungen (nicht dargestellt) von durchkontaktierten Löchern (nicht dargestellt) auf der Leiterplatte 26. Hierdurch erfolgt der Massekontakt nicht über die Federstifte 22, sondern direkt in der Art eines "surface mount" zwischen Gehäuse 18 Leiterplatte und metallisierter Leiterplattenoberfläche. Die Federstifte 22 sind somit elektrisch überbrückt und gleichzeitig ist der Spalt zwischen Leiterplatte 26 und Gehäuse 18 von einer Abschirmung in Form des umlaufenden Federbleches umgeben und damit abgeschirmt. Hierdurch ist ferner der Kontakt zwischen dem Koaxialwinkelstecker 20 und der Leiterplatte 26 Impedanzkontrolliert.

Das Bemerkenswerte hierbei ist, daß weder der Koaxialwinkelstecker 20 noch die Oberflächengestaltung der Leiterplatte 26 angepaßt werden müssen. Das Federblech 10 nützt die bereits vorhandenen Gegebenheiten aus, nämlich daß das Gehäuse 18 des Koaxialwinkelsteckers 20 aus Metall ist und daß die Leiterbeschichtung von Durchkontaktierungen bis zur Oberfläche der Leiterplatte reicht. Somit wird bei Rückwärtskompatibilität bzgl. bereits vorhandenen Prozessen und Komponenten eine bzgl. HF-Charakteristik wesentlich verbesserte Kontaktierung zwischen Koaxialwinkelstecker 20 und Leiterplatte 26 erzielt. Die Abstrahlung und Einkopplung von HF-Energie im Bereich des Spaltes zwischen Koaxialwinkelstekker 20 und Leiterplatte 26 bzw. über die Federstifte 22, 24 ist wesentlich reduziert, wodurch die gesamte Schaltungsanordnung ohne Modifikationen, beispielsweise am Layout der Schaltung auf der Leiterplatte 26, auch bei höheren Frequenzen betrieben werden kann. Auch eine örtliche Nähe eines HF-Pfades und eines digitalen Pfades auf der Leiterplatte 26 ist unkritisch.

Alternativ ist auf der Leiterplatte 26 statt der Metallisierung der Löcher für die Federstifte 22 ein sogen. Footprint vorgesehen, der entsprechende Kontaktflächen für das Federblech 10 auf der Leiterplatte 26 zur Verfügung stellt.

Im Ergebnis ist in vorteilhafter Weise immer die Funktion der Halterung des Bauteils 20 von der Funktion der elektrischen Kontaktierung des Bauteils 20 mit einer Schaltung auf der Leiterplatte 26 getrennt. Die Federstifte 22 dienen ausschließlich der Halterung, während das Federblech 10 ausschließlich der Kontaktierung dient.

## Patentansprüche

1. Federblech (10) für ein elektrisches bzw. elektronisches Bauteil (20) mit Federstiften (22, 24) zum Befestigen auf einer Leiterplatte (26),
**dadurch gekennzeichnet,**
**dass** das Federblech (10) als Quadrat mit einer mittigen kreisförmigen Ausnehmung (12) ausgebildet ist, wobei die kreisförmige Ausnehmung (12) auf den Diagonalen des Quadrats zusätzliche Ausbuchtungen (14) aufweist, wobei das Federblech (10) wenigstens eine federnde, bogenförmige Erhebung (16) aufweist, so dass wenn das Federblech (10) zwischen Bauteil (20) und Leiterplatte (26) angeordnet ist wenigstens ein elektrischer Kontakt zwischen wenigstens einem Teil (18) des Bauteils (20) und wenigstens einer entsprechenden Kontaktfläche auf der Leiterplatte (26) hergestellt ist.

2. Schaltungsanordnung mit einer Leiterplatte (26) und wenigstens einem elektrischen bzw. elektronischen Bauteil (20) mit Federstiften (22, 24) zum Befestigen des Bauteils (20) auf der Leiterplatte (26),
**dadurch gekennzeichnet,**
**dass** zwischen Leiterplatte (26) und wenigstens einem Bauteil (20) ein Federblech (10) angeordnet ist, welches als Quadrat mit einer mittigen kreisförmigen Ausnehmung (12) ausgebildet ist, wobei die kreisförmige Ausnehmung (12) auf den Diagonalen des Quadrats zusätzliche Ausbuchtungen (14) aufweist und wobei das Federblech (10) wenigstens eine federnde, bogenförmige Erhebung (16) aufweist, so dass das Federblech (10) wenigstens einen elektrischen Kontakt zwischen wenigstens einem Teil des Bauteils (20) und wenigstens einer entsprechenden Kontaktfläche auf der Leiterplatte (26) anstatt wenigstens eines Federstiftes (22) herstellt.

3. Schaltungsanordnung nach Anspruch 2, **dadurch gekennzeichnet, dass** das Bauteil (20) ein Gehäuse (18) aus einem leitenden Werkstoff aufweist und das Federblech (10) derart ausgebildet ist, daß es einen elektrischen Kontakt zwischen dem Gehäuse (18) und entsprechenden Massekontakten auf der Leiterplatte (26) herstellt.

4. Schaltungsanordnung nach Anspruch 2 oder 3, **dadurch gekennzeichnet, dass** das Bauteil (20) ein HF-Bauteil, insbesondere ein Koaxialkuppler, ist.

5. Schaltungsanordnung nach einem der Ansprüche 2 bis 4, **dadurch gekennzeichnet, daß** dieses eine Umfangsgeometrie aufweist, welche einer Umfangsgeometrie des Bauteils (20) entspricht, und im Bereich der Federstifte (22, 24) des Bauteils (20) wenigstens eine Ausnehmung (12, 14) aufweist.

6. Schaltungsanordnung nach einem der Ansprüche 2 bis 5, **dadurch gekennzeichnet, dass** die Kontaktfläche auf der Leiterplatte (26) wenigstens eine Leiterbeschichtung einer Durchkontaktierung der Leiterplatte (26) umfaßt.

7. Schaltungsanordnung nach einem der Ansprüche 2 bis 6, **dadurch gekennzeichnet, dass** die Kontaktfläche auf der Leiterplatte (26) wenigstens einen Footprint auf der Leiterplatte (26) umfaßt.

## Claims

1. Spring plate (10) for an electrical or electronic component (20) with spring pins (22, 24) for attachment on a circuit board (26), **characterised in that** the spring leaf (10) is formed as a square with a central circular cut-out (12), whereby the circular cut-out (12) has additional projections (14) on the diagonals of the square, whereby the spring plate (10) has at least one sprung, arch-shaped elevation (16) such that if the spring plate (10) is arranged between a component (20) and a circuit board (26), at least one electrical contact is created between at least one member (18) of the component (20) and at least one corresponding contact surface on the circuit board (26).

2. Circuit arrangement with a circuit board (26) and at least one electrical or electronic component (20) with spring pins (22, 24) for attachment of the component (20) on the circuit board (26), **characterised in that** arranged between the circuit board (26) and the at least one component (20) is a spring plate (10) which is designed as a square with a central circular cut-out (12), whereby the circular cut-out (12) has additional projections (14) on the diagonals of the square and whereby the spring plate (10) has at least one sprung, arch-shaped elevation (16) such that the spring plate (10) makes at least one electrical contact between at least one member of the component (20) and at least one corresponding contact surface on the circuit board (26) in place of at least one spring pin (22).

3. Circuit arrangement according to claim 2, **characterised in that** the component (20) has a housing (18) made of a conducting material and the spring plate (10) is designed such that it creates an electrical contact between the housing (18) and corresponding earth contacts on the circuit board (26).

4. Circuit arrangement according to claim 2 or 3, **characterised in that** the component (20) is an HF component, in particular a coaxial coupler.

5. Circuit arrangement according to one of the claims 2 to 4, **characterised in that** it has a peripheral geometry which corresponds to the peripheral geometry of the component (20) and in the region of the spring pins (22, 24) of the component (20), has at least one cut-out (12, 14).

6. Circuit arrangement according to one of the claims 2 to 5, **characterised in that** the contact surface on the circuit board (26) includes at least one conductor coating of a through-contact of the circuit board (26).

7. Circuit arrangement according to one of the claims 2 to 6, **characterised in that** the contact surface on the circuit board (26) includes at least one footprint on the circuit board (26).

## Revendications

1. Tôle à ressort (10) pour un composant (20) électrique ou électronique, comportant des fiches élastiques (22, 24) pour une fixation sur une carte à circuits imprimés (26),
**caractérisée en ce que** la tôle à ressort (10) est réalisée sous forme de carré avec un creux (12) circulaire médian, le creux (12) circulaire présentant sur les diagonales du carré des évidements (14) additionnels, la tôle à ressort (10) présentant au moins un relief (16) en forme d'arc à effet de ressort, de telle sorte que lorsque la tôle à ressort (10) est agencée entre le composant (20) et la carte à circuits imprimés (26), au moins un contact électrique est établi entre au moins une partie (18) du composant (20) et au moins une surface de contact correspondante sur la carte à circuits imprimés (26).

2. Agencement de circuit comportant une carte à circuits imprimés (26) et au moins un composant (20) électrique ou électronique avec des fiches élastiques pour fixer le composant (20) sur la carte à circuits imprimés (26),
**caractérisé en ce que**, entre la carte à circuits imprimés (26) et au moins un composant (20), est agencée une tôle à ressort (10) qui est réalisée sous forme de carré avec un creux (12) circulaire médian, le creux (12) circulaire présentant sur les diagonales du carré des évidements (14) additionnels, la tôle à ressort (10) présentant au moins un relief (16) en forme d'arc à effet de ressort, de telle sorte que la tôle à ressort (10) établit au moins un contact électrique entre au moins une partie du composant (20) et au moins une surface de contact correspondante sur la carte à circuits imprimés (26), à la place d'au moins une fiche élastique (22).

3. Agencement de circuit selon la revendication 2, **caractérisé en ce que** le composant (20) présente un boîtier (18) en un matériau conducteur, et la tôle à ressort (10) est réalisée de telle sorte qu'elle établit un contact électrique entre le boîtier (18) et des contacts de masse correspondants sur la carte à circuits imprimés (26).

4. Agencement de circuit selon l'une ou l'autre des revendications 2 et 3, **caractérisé en ce que** le composant (20) est un composant HF, en particulier un coupleur coaxial.

5. Agencement de circuit selon l'une des revendications 2 à 4, **caractérisé en ce que** celui-ci présente une géométrie de périphérie qui correspond à la géométrie de périphérie du composant (20), et **en ce qu'**il présente au moins un creux (12, 14) dans la région des fiches élastiques (22, 24) du composant (20).

6. Agencement de circuit selon l'une des revendications 2 à 5, **caractérisé en ce que** la surface de contact sur la carte à circuits imprimés (26) comprend au moins un revêtement conducteur d'une métallisation des trous de la carte à circuits imprimés (26).

7. Agencement de circuit selon l'une des revendications 2 à 6, **caractérisé en ce que** la surface de contact sur la carte à circuits imprimés (26) comprend au moins une empreinte sur la carte à circuits imprimés (26).
